# EUROPÄISCHE PATENTSCHRIFT

(11) **EP 2 891 179 B1**
(45) Veröffentlichungstag und Bekanntmachung des Hinweises auf die Patenterteilung: **05.10.2016**
(21) Anmeldenummer: 13752880.8
(22) Anmeldetag: 13.08.2013
(51) Int. Cl.: H01L 27/02, H02H 9/04, H02H 1/00

(54) **SCHUTZSCHALTUNG UND VERFAHREN ZUM SCHUTZ EINER SCHALTUNG**
PROTECTION CIRCUIT AND METHOD FOR PROTECTING A CIRCUIT
CIRCUIT DE PROTECTION ET PROCÉDÉ DE PROTECTION D'UN CIRCUIT

(30) Priorität: 31.08.2012 DE 102012108105
(43) Veröffentlichungstag der Anmeldung: 08.07.2015
(60) Teilanmeldung: 16179505.9
(73) Patentinhaber: AMS AG, 8141 Unterpremstätten (AT)
(72) Erfinder: REINPRECHT, Wolfgang, A-8144 Tobelbad (AT); STOCKREITER, Christian, A-8045 Graz (AT); WEISS, Bernhard, A-8020 Graz (AT)
(74) Vertreter: Epping - Hermann - Fischer
(86) Internationale Anmeldenummer: PCT/EP2013/066922
(87) Internationale Veröffentlichungsnummer: WO 2014/032965

(56) Entgegenhaltungen:
- US-A1- 2003 214 768
- US-A1- 2012 002 337
- US-A1- 2012 170 160
- US-B1- 7 102 862

## Beschreibung

Die Erfindung betrifft eine Schutzschaltung und ein Verfahren zum Schutz einer Schaltung.

Eine Schutzschaltung dient üblicherweise dem Schutz eines Anschlusses vor elektrostatischer Entladung, englisch electrostatic discharge, abgekürzt ESD. Integrierte Schaltungen, die im Automobil verwendet werden, weisen Schutzschaltungen auf. Derartige integrierte Schaltungen werden beispielsweise in einem Local Interconnect Network, abgekürzt LIN, eingesetzt.

Im Betrieb kann jedoch eine hochfrequente Störung (Funkstörung) auftreten, die durch eine auf Direct Power Injection, abgekürzt DPI, auch direkte Leistungseinbringung genannt, basierende Testmethode geprüft wird. Die Frequenzen im Hochfrequenzstörungs-Fall liegen zwischen 1 MHz und 1 GHz. Das hohe Spannungsniveau und die schnellen Übergänge eines Hochfrequenzstörungs-Signals bewirken, dass eine herkömmliche Schutzstruktur leitet und Strom durch die Schutzstruktur fließt. Eine herkömmliche Schutzstruktur reagiert daher auch auf diese Frequenzen, um eine sichere Ableitung während eines ESD-Ereignisses zu gewährleisten. Üblicherweise ist der relevante Frequenzbereich, der Auswirkungen auf eine Schutzstruktur hat, zwischen 1 MHz und 100 MHz. Eine Schutzschaltung soll daher nicht bei einem Hochfrequenzstörungs-Ereignis auslösen, um eine Störung an einem Knoten des LIN und einen Verlust der Kommunikation zu vermeiden.

Dokument US 2009/0128969 A1 beschreibt einen adaptiven Schutz gegenüber ESD für einen LIN-Bus. Eine Schutzstruktur umfasst einen Feldeffekttransistor, der einen Anschluss mit einem Bezugspotentialanschluss koppelt. Im Fall einer Hochfrequenzstörung wird ein Steueranschluss des Feldeffekttransistors an den Bezugspotentialanschluss angeschlossen.

In Dokument US 7,102,862 B1 ist eine Schutzschaltung gegen elektrostatische Entladung erläutert. Die Schutzschaltung umfasst einen Hochspannungsanschluss, einen Niederspannungsanschluss, eine Triggerschaltung und eine Entladungsschaltung, welche einen NMOS-Transistor umfasst. Die Triggerschaltung leitet ein Triggersignal einem Steueranschluss des NMOS-Transistors zu. Dabei wird in einem normalen Betriebszustand ein niedriger Wert des Triggersignals dem NMOS-Transistor zugeleitet, so dass der NMOS-Transistor sperrt. Während eines ESD-Ereignisses wird ein hoher Wert des Triggersignals dem Steueranschluss des NMOS-Transistors zugeführt, so dass der NMOS-Transistor leitet. Die Triggerschaltung wird von einer Spannung versorgt, die am Hochspannungsanschluss anliegt.

Dokument US 2003/0214768 A1 beschreibt eine schnell auslösende ESD-MOSFET-Schutzschaltung, die einen ersten Knoten, einen Shunt-Transistor und einen zweiten Knoten umfasst, an dem ein Bezugspotential anliegt. Der Shunt-Transistor ist als NMOS-Transistor realisiert und verbindet den ersten Knoten mit dem zweiten Knoten. Der Shunt-Transistor sperrt bei einem niedrigen Wert seiner Steuerspannung und leitet bei einem hohen Wert seiner Steuerspannung. Weiter umfasst die Schutzschaltung einen Spannungsgenerator mit einer Ladungspumpenschaltung, die über eine weitere Schaltung mit dem ersten Knoten und über einen Widerstand mit einem Steueranschluss des Shunt-Transistors verbunden ist.

Eine Aufgabe der vorliegenden Erfindung ist es, eine Schutzschaltung und ein Verfahren zum Schutz einer Schaltung bereitzustellen, die ohne Verwendung eines niedrigen Steuersignals ein Auslösen der Schutzstruktur im Fall einer Hochfrequenzstörung verhindern.

Die Aufgabe wird mit dem Gegenstand des Anspruchs 1 sowie dem Verfahren mit den Merkmalen gemäß Anspruch 10 gelöst. Weiterbildungen und Ausgestaltungen sind Gegenstand der abhängigen Ansprüche.

In einer Ausführungsform umfasst eine Schutzschaltung einen Anschluss, einen Bezugspotentialanschluss, eine Schutzstruktur und eine Spannungsversorgungsschaltung. Die Schutzstruktur ist zwischen dem Anschluss und dem Bezugspotentialanschluss angeordnet. Die Spannungsversorgungsschaltung ist ausgangsseitig mit einem Steuereingang der Schutzstruktur gekoppelt. Die Schutzstruktur ist ausgelegt, im Fall einer elektrostatischen Entladung zu leiten. Die Spannungsversorgungsschaltung ist ausgelegt, im Fall einer Hochfrequenzstörung dem Steuereingang ein Steuersignal mit einem derartig hohen Spannungswert zuzuführen, dass das Leiten der Schutzstruktur verhindert ist.

Mit Vorteil wird während einer Hochfrequenzstörung ein Steuersignal mit einem hohen Spannungswert generiert, sodass im Fall einer Hochfrequenzstörung die Schutzstruktur, für deren Inaktivierung ein hoher Spannungswert notwendig ist, nicht leitet. Mit Vorteil ist somit die Schutzschaltung ausgelegt, ausschließlich im Fall einer elektrostatischen Entladung und nicht im Fall einer Hochfrequenzstörung zu leiten.

Die Hochfrequenzstörung kann durch eine Direct Power Injection verursacht oder nachgebildet sein. Die Spannungsversorgungsschaltung kann ausgelegt sein, bei Hochfrequenzstörungen im Bereich zwischen 1 MHz und 1 GHz das Steuersignal mit dem hohen Spannungswert zu erzeugen. Die Spannungsversorgungsschaltung kann derart realisiert sein, dass sie den hohen Spannungswert des Steuersignals bei einem Nutzsignal wie etwa einem Datensignal am Anschluss nicht bereitstellt. In einer Ausführungsform weist das Nutzsignal eine Datenrate kleiner als 1 MHz auf.

Der Anschluss kann als Input/Output Anschluss realisiert sein. Ein Bus, insbesondere ein LIN Bus, kann den Anschluss umfassen. Eine Datenrate eines am Anschluss anliegenden Anschlusssignals kann beispielsweise maximal 1 MHz betragen.

In einer Ausführungsform bewirkt mit Vorteil die Spannungsversorgungsschaltung, dass eine über den Anschluss durchgeführte Kommunikation durch eine erhöhte Stromaufnahme oder Kopplung nicht gestört wird. Auch eine Hochfrequenzstörung führt nicht zum Ausfall der Kommunikation, da die Kommunikation am Bus nicht gestört wird.

In einer Ausführungsform führt ein Einschalten der Schutzstruktur nicht zu einer Zerstörung der Schutzstruktur. Auch ein DPI Ereignis bewirkt keine Zerstörung der Schutzstruktur.

In einer Ausführungsform verhindert die Spannungsversorgungsschaltung ausschließlich im Fall einer Hochfrequenzstörung das Leiten der Schutzstruktur. Ein falsches Triggern der Schutzstruktur wird somit vermieden. Die Schutzstruktur leitet ausschließlich im ESD-Fall, nicht jedoch bei einer Hochfrequenzstörung.

In einer Ausführungsform weist bei einer Hochfrequenzstörung das Anschlusssignal Frequenzen zwischen 1 MHz und 1 GHz auf.

In einer Ausführungsform weist ein bei einer Hochfrequenzstörung auftretendes Anschlusssignal Frequenzen auf, die höher als eine maximale Arbeitsfrequenz sind. Die maximale Arbeitsfrequenz kann beispielsweise 1 MHz betragen.

In einer Ausführungsform ist die Spannungsversorgungsschaltung eingangsseitig an den Anschluss angeschlossen.

In einer Ausführungsform ist ein Ausgang der Spannungsversorgungsschaltung an den Steuereingang angeschlossen. Der Ausgang der Spannungsversorgungsschaltung ist bei Abwesenheit einer Hochfrequenzstörung hochohmig. Die Spannungsversorgungsschaltung gibt somit in Abwesenheit einer Hochfrequenzstörung kein Steuersignal ab. Somit ist die Schutzstruktur bei Abwesenheit einer Hochfrequenzstörung unbeeinflusst von der Spannungsversorgungsschaltung durch ein ESD-Ereignis auslösbar. Die Schutzstruktur ist derart ausgelegt, dass sie selbsttätig ohne Mitwirkung der Spannungsversorgungsschaltung im ESD-Fall auslöst.

In einer Ausführungsform ist die Spannungsversorgungsschaltung als Ladungspumpe implementiert, die an einem ersten Eingang an den Anschluss und an einem Ausgang an den Steuereingang der Schutzstruktur angeschlossen ist.

Beispielsweise kann die Ladungspumpe die Steuerspannung aus einem am Anschluss anliegenden Anschlusssignal und/oder aus einer der Ladungspumpe zugeleiteten Versorgungsspannung generieren. Wahlweise konvertiert die Ladungspumpe das Anschlusssignal oder die Versorgungsspannung in die Steuerspannung, je nachdem welches der beiden Signale beziehungsweise Spannungen einen höheren Spannungswert hat.

In einer Ausführungsform kann mit Vorteil eine Ladungspumpe geeignet sein, eine höhere Spannung als Steuerspannung an den Steuereingang der Schutzstruktur abzugeben, als ihr momentan selber zugeleitet wird.

In einer Ausführungsform umfasst ein Verfahren zum Schutz einer Schaltung das Bereitstellen eines Steuersignals durch eine Spannungsversorgungsschaltung. Weiter wird das Steuersignal einer Schutzstruktur zugeführt, die zwischen einem Anschluss und einem Bezugspotentialanschluss angeordnet ist. Die Schutzstruktur ist ausgelegt, im Fall einer elektrostatischen Entladung zu leiten. Im Fall einer Hochfrequenzstörung wird das Steuersignal mit einem derartig hohen Spannungswert generiert, dass das Leiten der Schutzstruktur verhindert wird.

Mit Vorteil wird das Auslösen der Schutzstruktur durch den hohen Spannungswert des Steuersignals deaktiviert.

In einer Ausführungsform umfasst ein Halbleiterkörper eine Schutzschaltung mit der Schutzstruktur und der Spannungsversorgungsschaltung. Ein Schaltkreis des Halbleiterkörpers kann mit Vorteil eine Signalkommunikation auch bei einer Hochfrequenzstörung aufrechterhalten. Dies ist von Vorteil für einen Halbleiterkörper, der im Automobil eingesetzt ist. Auch die zwischen 1 MHz und 1 GHz liegenden Frequenzen der Hochfrequenzstörung bewirken kein Auslösen der Schutzstruktur. Bei einem Hochfrequenzstörungs-Ereignis ist ein Knoten des Local Interconnect Networks, mit dem der Halbleiterkörper verbunden ist, nicht gestört und es tritt kein Verlust der Kommunikation auf.

Die Erfindung wird im Folgenden an mehreren Ausführungsbeispielen anhand der Figuren näher erläutert. Funktions- beziehungsweise wirkungsgleiche Bauelemente oder Schaltungsteile tragen gleiche Bezugszeichen. Insoweit sich Bauelemente oder Schaltungsteile in ihrer Funktion entsprechen, wird deren Beschreibung nicht in jeder der folgenden Figuren wiederholt. Es zeigen:
- Figuren 1A bis 1K: beispielhafte Ausführungsformen einer Schutzschaltung und
- Figur 2: eine beispielhafte Ausführungsform eines Halbleiterkörpers mit der Schutzschaltung.

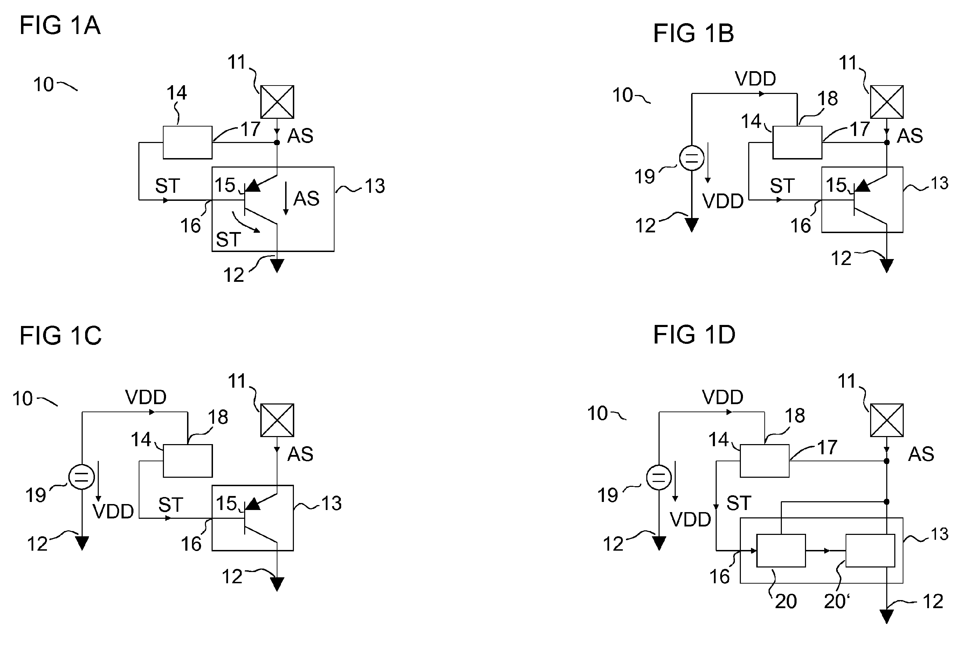

Figur 1A zeigt eine beispielhafte Ausführungsform einer Schutzschaltung 10. Die Schutzschaltung 10 umfasst einen Anschluss 11, einen Bezugspotentialanschluss 12, eine Schutzstruktur 13 und eine Spannungsversorgungsschaltung 14. Der Anschluss 11 kann beispielsweise als Input/Output-Pin realisiert sein. Der Anschluss 11 ist typischerweise ein Anschluss, bei dem ein Hochfrequenzstörungs-Ereignis auftreten kann. Die Schutzstruktur 13 umfasst einen Bipolartransistor 15. Der Bipolartransistor ist als PNP-Bipolartransistor implementiert. Der Bipolartransistor 15 umfasst einen Emitter, der direkt an den Anschluss 11 angeschlossen ist. Weiter umfasst der Bipolartransistor 15 einen Kollektor, der direkt an den Bezugspotentialanschluss 12 angeschlossen ist. Darüber hinaus umfasst der Bipolartransistor 15 eine Basis, die mit einem Steuereingang 16 der Schutzstruktur 13 gekoppelt ist. Die Spannungsversorgungsschaltung 14 ist an einem ersten Eingang 17 an den Anschluss 11 angeschlossen. An einem Ausgang ist die Spannungsversorgungsschaltung 14 an den Steuereingang 16 angeschlossen. Die Spannungsversorgungsschaltung 14 ist als Ladungspumpe implementiert, die an einem ersten Eingang an den Anschluss 11 und an einem Ausgang an den Steuereingang 16 angeschlossen ist.

Am Anschluss 11 liegt ein Anschlusssignal AS an, das der Spannungsversorgungsschaltung 14 zugeleitet wird. Die Spannungsversorgungsschaltung 14 gibt ein Steuersignal ST ab. Die Spannungsversorgungsschaltung 14 erzeugt das Steuersignal ST in Abhängigkeit vom Anschlusssignal AS. Das Steuersignal ST wird dem Steuereingang 16 und damit der Basis des Bipolartransistors 15 zugeleitet. Das Steuersignal ST liegt in Form einer Spannung zwischen der Basis und dem Kollektor des Bipolartransistors 15 an. Das Anschlusssignal AS fällt zwischen dem Emitter und dem Kollektor des Bipolartransistors 15 ab. Die Schutzstruktur 13 leitet, sobald eine elektrostatische Entladung am Anschluss 11 vorliegt. Im ESD-Fall führt der Bipolartransistor 15 Strom vom Anschluss 11 zum Bezugspotentialanschluss 12.

Die Spannungsversorgungsschaltung stellt im Fall einer Hochfrequenzstörung das Steuersignal ST mit einem Spannungswert bereit, der über einem vorgegebenen Spannungswert ist. Die Schutzstruktur 13 leitet ausschließlich bei Spannungswerten des Steuersignals ST unter dem vorgegebenen Spannungswert. Somit wird im Fall einer Hochfrequenzstörung das Leiten der Schutzstruktur 13 durch das über dem vorgegebenen Spannungswert liegende Steuersignal ST verhindert. Die Ladungspumpe wird von der Spannung am Anschluss 11 versorgt. Die Kapazität am Anschluss 11 ist groß genug, um die zusätzliche Last zu treiben, die durch die Ladungspumpe hervorgerufen wird, ohne dass eine Störung des Anschlusssignals AS auftritt.

Durch das Steuersignal ST bei einem Hochfrequenzstörungs-Ereignis wird die Basis des Bipolartransistors 15 vorgespannt. Das Steuersignal ST weist im Hochfrequenzstörungs-Fall eine derart hohe Spannung auf, dass der Bipolartransistor 15 nicht leitet. Das Steuersignal ST weist im Hochfrequenzstörungs-Fall mindestens den Spannungswert des Anschlusssignals AS abzüglich einer Schwellspannung einer Diode, englisch cut-in voltage, auf. Ebenso bleibt jedes aktive oder parasitäre Bauelement, an dem das Steuersignal ST anliegt, bei einem Hochfrequenzstörungs-Ereignis im Zustand der umgekehrten Vorspannung, sodass ein Auslösen verhindert ist. Die Spannungsversorgungsschaltung 14 ist im Fall einer Hochfrequenzstörung eingeschaltet.

Die Spannungsversorgungsschaltung 14 ist ausgeschaltet, während ein ESD-Ereignis vorliegt. Somit ist eine Spannung des Steuersignals ST während eines ESD-Ereignisses aus. Folglich ist bei einem ESD-Ereignis der Basis-Emitter-Übergang des Bipolartransistors 15 eingeschaltet und der ESD-Schutz aktiviert, so dass die Schutzstruktur 13 leitet. Die Schutzstruktur 13 ist selbstauslösend bei einem ESD-Ereignis.

In einer Ausführungsform stellt die Ladungspumpe das Steuersignal ST mit einem höheren Spannungswert als den Spannungswert des Anschlusssignals AS bereit. Da der Basis des Bipolartransistors 15 somit eine höhere Spannung zugeführt wird als am Anschluss 11 und damit am Emitter des Bipolartransistors 15 anliegt, ist die Leitung der Schutzstruktur 13 während eines Hochfrequenzstörungs-Ereignisses verhindert.

In einer alternativen, nicht gezeigten Ausführungsform wird das Steuersignal ST einem weiteren Knoten oder Anschluss zur Versorgung eines Schaltkreises zugeleitet. So kann der weitere Knoten, der im Fall einer Hochfrequenzstörung vorgespannt werden soll, durch die Spannungsversorgungsschaltung 14 versorgt werden.

Figur 1B zeigt eine weitere beispielhafte Ausführungsform einer Schutzschaltung 10, die eine Weiterbildung der in Figur 1A gezeigten Ausführungsform ist. Die Spannungsversorgungsschaltung 14 weist einen zweiten Eingang 18 auf. Der zweite Eingang 18 ist mit einer Spannungsquelle 19 der Schutzschaltung 10 verbunden. Dem zweiten Eingang 18 wird eine Versorgungsspannung VDD zugeleitet, die von der Spannungsquelle 19 abgegeben wird. Die als Ladungspumpe realisierte Spannungsversorgungsschaltung 14 wird somit von der Versorgungsspannung VDD und vom Anschlusssignal AS versorgt. Mit Vorteil wird dadurch eine von der Spannungsversorgungsschaltung 14 verursachte Last am Anschluss 11 verringert.

Die Spannungsversorgungsschaltung 14 konvertiert das Anschlusssignal AS oder die Versorgungsspannung VDD in das Steuersignal ST. Die Spannungsversorgungsschaltung 14 ist realisiert, das Anschlusssignal AS in das Steuersignal ST zu wandeln, wenn der Spannungswert des Anschlusssignals AS höher als der Wert der Versorgungsspannung VDD ist, und die Versorgungsspannung VDD in das Steuersignal ST zu wandeln, wenn der Wert der Versorgungsspannung VDD höher als der Spannungswert des Anschlusssignals AS ist. Das Steuersignal ST kann beispielsweise gleich der höheren Spannung aus einer Gruppe, umfassend die Spannung des Anschlusssignals AS und die Versorgungsspannung VDD, sein.

Über die beiden Eingänge 17, 18 der Spannungsversorgungsschaltung 14 beziehungsweise der Ladungspumpe werden einerseits die Versorgungsspannung VDD und andererseits das Anschlusssignal AS in das Steuersignal ST konvertiert, welche Spannung auch immer höher ist. Die höhere Spannung bewirkt, dass sowohl die Basis-Kollektor Diode als auch die Basis-Emitter Diode des Bipolartransistors 15 in Sperrrichtung vorgespannt sind und dadurch die Raumladungszonen breit sowie die Kapazitäten entsprechend klein werden. Dies wiederum reduziert die Stromaufnahme bei einer DPI Störung, die maßgeblich die Signalintegrität sicherstellt. Ein zu großer Stromwert würde die Kommunikation am Bus stören. Die Schutzschaltung 10, auch ESD Schaltung genannt, triggert außer im ESD Fall nicht. Daher beeinflusst die Schutzschaltung 10 die Signale am LIN-Bus, der den Anschluss 11 umfasst, unter Störeinfluss nicht.

Figur 1C zeigt eine weitere beispielhafte Ausführungsform der Schutzstruktur 10, die eine Weiterbildung der in den Figuren 1A und 1B gezeigten Ausführungsformen ist. Gemäß Figur 1C wird die Spannungsversorgungsschaltung 14 ausschließlich von der Versorgungsspannung VDD versorgt. Die Spannungsversorgungsschaltung 14 ist ohne Verbindung zum Anschluss 11. Eine derartige Schutzschaltung kann beispielsweise verwendet werden, wenn im Fall eines Hochfrequenzstörungs-Ereignisses sowohl das Anschlusssignal AS wie auch die Versorgungsspannung VDD beeinflusst werden. Somit ist eine Kopplung des Anschlusses 11 zur Spannungsversorgungsschaltung 14 nicht erforderlich, um das Vorliegen der Hochfrequenzstörung festzustellen. Somit wird mit Vorteil eine Last am Anschluss 11 weiter verringert.

Figur 1D zeigt eine weitere beispielhafte Ausführungsform der Schutzschaltung 10, die eine Weiterbildung der in den Figuren 1A bis 1C gezeigten Ausführungsformen ist. Die Schutzstruktur 13 umfasst eine Auslöseschaltung 20, die an einem ersten Eingang an den Steuereingang 16 angeschlossen ist. An einen zweiten Eingang ist die Auslöseschaltung 20 an den Anschluss 11 angeschlossen. An einem Ausgang ist die Auslöseschaltung 20 an einen Steueranschluss eines Schutzstrukturbauelements 20' angeschlossen. Das Schutzstrukturbauelement 20' kann der in den Figuren 1A bis 1C gezeigte Bipolartransistor 15 sein. Die Auslöseschaltung 20 kann somit an die Basis des Bipolartransistors 15 angeschlossen sein. Um eine Leitung der Schutzstruktur 13 während eines Hochfrequenzstörungs-Ereignisses auszuschließen, wird das Schutzstrukturbauelement 20' von der Spannungsversorgungsschaltung 14 über die Auslöseschaltung 20 ausgeschaltet. Die Auslöseschaltung 20 ist somit im Fall eines Hochfrequenzstörungs-Signals am Anschluss 11 deaktiviert. Die Auslöseschaltung 20 wird durch das Vorliegen des Steuersignals ST über dem vorgegebenen Spannungswert deaktiviert. Gibt die Spannungsversorgungsschaltung 14 keine Spannung als Steuersignal ST ab, so ist die Auslöseschaltung 20 aktiviert. Sobald die Auslöseschaltung 20 ein ESD-Ereignis erkennt, schaltet sie die Schutzstruktur 13 leitend. Im ESD-Zustand befinden sich die Versorgungsspannung VDD und der Spannungswert des Anschlusssignals AS üblicherweise nicht auf demselben Spannungsniveau.

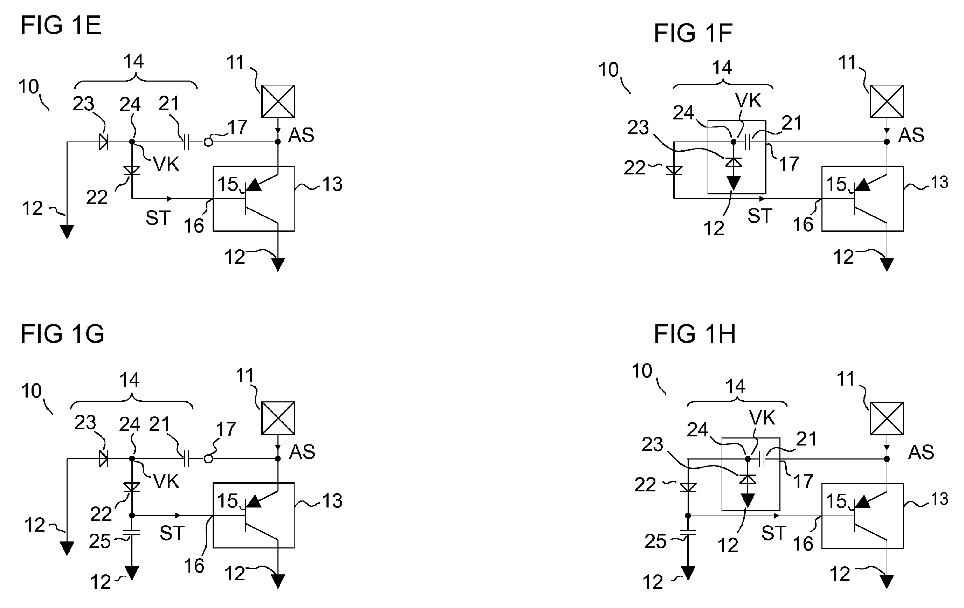

Figur 1E zeigt eine weitere beispielhafte Ausführungsform der Schutzschaltung 10, die eine Weiterbildung der in den Figuren 1A bis 1D gezeigten Ausführungsformen ist. Die Spannungsversorgungsschaltung 14 umfasst einen Koppelkondensator 21 und eine erste Diode 22, welche eine Serienschaltung bilden. Die Serienschaltung, umfassend den Koppelkondensator 21 und die erste Diode 22, ist zwischen dem Anschluss 11 und dem Steuereingang 16 angeordnet. Dabei ist der Koppelkondensator 21 an den Anschluss 11 und die erste Diode 22 an den Steuereingang 16 angeschlossen. Eine Anode der ersten Diode 22 ist an den Koppelkondensator 21 und eine Kathode der ersten Diode 21 ist an den Steuereingang 16 angeschlossen. Weiter umfasst die Spannungsversorgungsschaltung 14 eine zweite Diode 23, die den Bezugspotentialanschluss 12 mit einem Knoten 24 zwischen dem Koppelkondensator 21 und der ersten Diode 22 verbindet. Eine Anode der zweiten Diode 23 ist an den Bezugspotentialanschluss 12 und eine Kathode der zweiten Diode 23 ist an den Knoten 24 angeschlossen.

Im Fall eines Hochfrequenzstörungs-Ereignisses weist das Anschlusssignal AS Frequenzen beispielsweise im Bereich zwischen 1 MHz und 1 GHz auf. Daher stellt im Fall eines Hoch-frequenzstörungs-Ereignisses der Koppelkondensator 21 einen nur geringfügigen Wechselspannungswiderstand dar. Eine Knotenspannung VK am Knoten 24 kann somit hohe Spannungswerte annehmen, die zu einer Leitung der ersten Diode 22 führen. Hohe Werte der Knotenspannung VK führen somit zu einem Anstieg des Steuersignals ST. Ein Steuersignal ST, das positive Werte aufweist, bewirkt eine Blockierung der Emitter-Basis-Diode des Bipolartransistors 15. Die Kathode der ersten Diode 22, die Basis des Bipolartransistors 15 und die Leiterbahn zwischen der ersten Diode 22 und der Basis des Bipolartransistors 15 bilden eine parasitäre Kapazität, die über die Serienschaltung aus dem Koppelkondensator 21 und der ersten Diode 22 aufgeladen wird und den Spannungswert des Steuersignals ST auf einem hohen Wert stabilisiert.

Die zweite Diode 23 bewirkt, dass die Knotenspannung VK als minimalen Wert den Wert des Bezugspotentialanschluss 0 Volt abzüglich des Werts einer Schwellspannung der zweiten Diode 23 annehmen kann. Dadurch dass die Knotenspannung VK keinen stark negativen Wert annehmen kann, gerät die erste Diode 22 nicht in den Zustand einer stark-sperrenden Vorspannung. Somit ist bei einem kurzzeitig hohen Spannungswert des Anschlusssignals AS im Hochfrequenzstörungs-Fall die erste Diode 22 sofort leitend und kann einen hohen Spannungswert des Steuersignals ST erzeugen. Nach dem Ende eines Hochfrequenzstörungs-Ereignisses wird der Spannungswert des Steuersignals ST über parasitäre Ströme durch die erste und die zweite Diode 22, 23 sowie den Basis-Kollektor-Übergang des Bipolartransistors 15 abgebaut. Die erste Diode 22 stellt einen hochohmigen Ausgang der Spannungsversorgungsschaltung 14 bei Abwesenheit eines Hochfrequenzstörungs-Ereignisses dar. Mit Vorteil weist die Spannungsversorgungsschaltung 14 nur sehr wenige Bauelemente auf und kann flächensparend realisiert werden.

Die erste und die zweite Diode 22, 23 wirken als Schalter. Die erste und die zweite Diode 22, 23 leiten ausschließlich dann, wenn ein Stromfluss durch die jeweilige Diode zu einer Erhöhung der Spannung des Steuersignals ST führt. Die Polung der Dioden 22, 23 ist so gewählt, dass ein Stromfluss durch die jeweilige Diode die Spannung des Steuersignals ST erhöht.

Bei einem Hochfrequenzstörungs-Fall kann das Anschlusssignal AS Spannungswerte von plus/minus 40 V aufweisen. Somit arbeiten die in den Figuren 1E bis 1K gezeigten Ausführungsformen der Spannungsversorgungsschaltung 14 als Ladungspumpen. Die Ladungspumpe steuert sich selbsttätig.

In alternativen, nicht gezeigten Ausführungsformen können in den Figuren 1E bis 1I die Dioden 22, 23, 26 durch aktiv gesteuerte Schalter ersetzt werden. Diese werden von einer nicht gezeigten Steuerung angesteuert. Damit kann eine aktiv mittels eine Steuerung gesteuerte Ladungspumpe implementiert werden.

Figur 1F zeigt eine weitere beispielhafte Ausführungsform der Schutzschaltung 10, die eine Weiterbildung der in den Figuren 1A bis 1E gezeigten Ausführungsformen ist. Die zweite Diode 23 und der Koppelkondensator 21 sind zusammen in einem Bauelement eines die Schutzschaltung 13 aufweisenden Hableiterkörpers integriert.

Figur 1G zeigt eine weitere beispielhafte Ausführungsform der Schutzschaltung 10, die eine Weiterbildung der in den Figuren 1A bis 1F gezeigten Ausführungsformen ist. Die Spannungsversorgungsschaltung 14 umfasst zusätzlich einen Pufferkondensator 25. Der Pufferkondensator 25 ist zwischen dem Steuereingang 16 und dem Bezugspotentialanschluss 12 angeordnet. Der Pufferkondensator 25 wird über die Serienschaltung aus dem Koppelkondensator 21 und der ersten Diode 22 aufgeladen. Das Steuersignal ST ist eine über dem Pufferkondensator 25 abfallende Spannung. Der Pufferkondensator 25 stabilisiert somit das Steuersignal ST. Das Steuersignal ST liegt im Hochfrequenzstörungs-Fall auf einem Spannungswert, der größer oder gleich dem Spannungswert des Anschlusssignals AS abzüglich einer Schwellspannung einer Diode ist, so dass die Basis-Emitter-Diode sperrt und der Bipolartransistor 15 nicht leitet. Somit ist im Hochfrequenzstörungs-Fall das Auslösen des Bipolartransistors 15 verhindert.

Figur 1H zeigt eine weitere beispielhafte Ausführungsform der Schutzschaltung 10, die eine Weiterbildung der in den Figuren 1A bis 1G gezeigten Ausführungsformen ist. Wie auch in Figur 1F ist in Figur 1H die zweite Diode 23 und der Koppelkondensator 21 in dem Halbleiterkörper als ein Bauelement auf einer Fläche integriert.

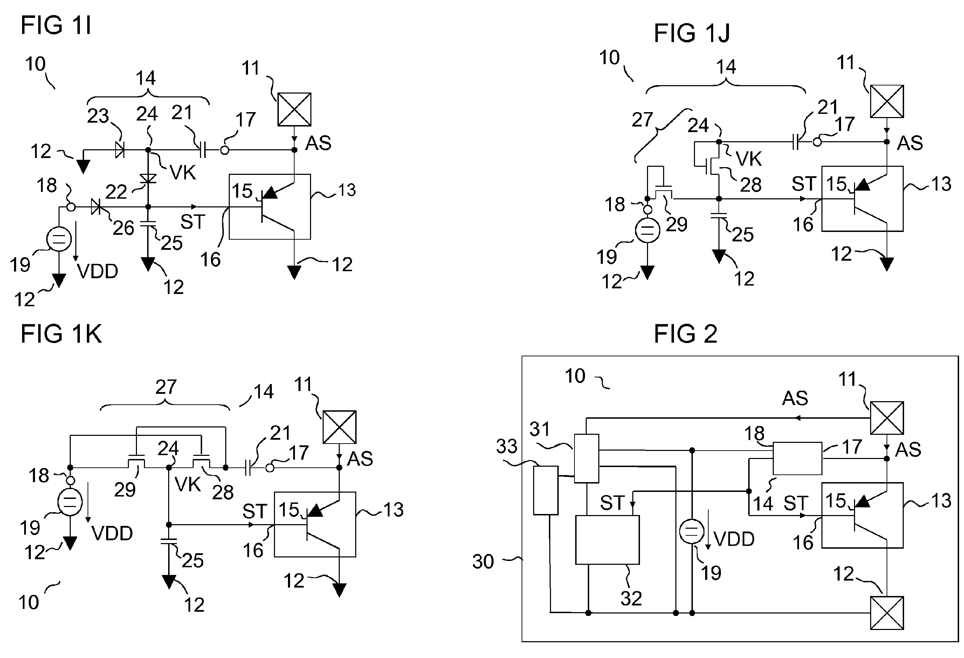

Figur 1I zeigt eine weitere beispielhafte Ausführungsform der Schutzschaltung 10, die eine Weiterbildung der in den Figuren 1A bis 1H gezeigten Ausführungsformen ist. Die Schutzschaltung 10 weist die Spannungsquelle 19 auf. Die Spannungsversorgungsschaltung 14 umfasst eine weitere Diode 26, welche die Spannungsquelle 19 mit dem Steuereingang 16 verbindet. Die Versorgungsspannung VDD wird somit über die weitere Diode 26 dem Steuereingang 16 zugeleitet. Die höhere der beiden Spannungen, nämlich die Versorgungsspannung VDD und die Knotenspannung VK am Knoten 24 zwischen dem Koppelkondensator 21 und der ersten Diode 22 bestimmt somit das Steuersignal ST. Das Steuersignal ST ist somit die höhere der beiden Spannungen, nämlich die Versorgungsspannung VDD abzüglich der Schwellspannung der ersten Diode 22 und die Knotenspannung VK abzüglich der Schwellspannung der weiteren Diode 26.

Figur 1J zeigt eine weitere beispielhafte Ausführungsform der Schutzschaltung, die eine Weiterbildung der in den Figuren 1A bis 1I gezeigten Ausführungsformen ist. Die Schutzschaltung umfasst eine Schaltmatrix 27. Ein erster Eingang der Schaltmatrix 27 ist über den Koppelkondensator 21 mit dem Anschluss 11 gekoppelt. Ein zweiter Eingang der Schaltmatrix 27 ist an die Spannungsquelle 19 angeschlossen. Ein Ausgang der Schaltmatrix 27 ist mit dem Steueranschluss 16 verbunden. Die Schaltmatrix 27 umfasst einen ersten und einen zweiten Transistor 28, 29, die den ersten beziehungsweise den zweiten Eingang der Schaltmatrix 27 mit dem Ausgang der Schaltmatrix 27 verbinden. Eine Serienschaltung umfasst den Koppelkondensator 21 und eine gesteuerte Strecke des ersten Transistors 28 und ist zwischen dem Anschluss 11 und dem Steuereingang 16 angeordnet. Ein Steueranschluss des ersten Transistors 28 ist an den Knoten 24 zwischen dem Koppelkondensator 21 und der gesteuerten Strecke des ersten Transistors 28 angeschlossen.

Der zweite Transistor 29 ist zwischen der Spannungsquelle 19 und dem Steuereingang 16 angeordnet. Ein Steueranschluss des zweiten Transistors 29 ist an einen Knoten zwischen der Spannungsquelle 19 und der gesteuerten Strecke des zweiten Transistors 29 angeschlossen. Der erste und der zweite Transistor 28, 29 sind als Feldeffekttransistoren realisiert. Der erste und der zweite Transistor 28, 29 sind als n-Kanal Metall-Oxid-Halbleiter Feldeffekttransistoren implementiert. Ist das Steuersignal ST kleiner als die Knotenspannung VK am Knoten 24, so leitet der erste Transistor 28 und lädt den Pufferkondensator 25 auf. Ist hingegen das Steuersignal ST kleiner als die Versorgungsspannung VDD, so leitet der zweite Transistor 29 und lädt den Pufferkondensator 25 auf. Der erste und der zweite Transistor 28, 29 sind somit an der Stelle der ersten und der weiteren Diode 22, 26 angeordnet. Die erste und die weitere Diode 22, 26 können somit mittels als Dioden geschaltete Transistoren 28, 29 implementiert werden.

Figur 1K zeigt eine weitere beispielhafte Ausführungsform der Schutzschaltung 10, die eine Weiterbildung der in den Figuren 1A bis 1J gezeigten Ausführungsformen ist. Der Steueranschluss des ersten Transistors 28 ist an den Knoten zwischen der Spannungsquelle 19 und der gesteuerten Strecke des zweiten Transistors 29 angeschlossen. Hingegen ist der Steueranschluss des zweiten Transistors 29 an den Knoten 24 zwischen der gesteuerten Strecke des ersten Transistors 28 und dem Koppelkondensator 21 angeschlossen. Der erste und der zweite Transistor 28, 29 sind als p-Kanal Metall-Oxid-Halbleiter Feldeffekttransistoren implementiert. Die Schaltmatrix 27 generiert somit die benötigten Steuersignale für den ersten und den zweiten Transistor 28, 29 selbst. Ist die Versorgungsspannung VDD klein gegenüber der Knotenspannung VK, so leitet der erste Transistor 28 und sperrt der zweite Transistor 29. Ist hingegen die Knotenspannung VK niedriger verglichen mit der Versorgungsspannung VDD, so leitet der zweite Transistor 29 und sperrt der erste Transistor 28.

Figur 2 zeigt eine beispielhafte Ausführungsform eines Halbleiterkörpers 30, welcher die Schutzschaltung 10 gemäß einer der in den Figuren 1A bis 1K gezeigten Ausführungsformen umfasst. Darüber hinaus umfasst der Halbleiterkörper 30 einen Treiber 31, der an den Anschluss 11 angeschlossen ist. Der Treiber 31 ist als Eingangstreiber realisiert. Alternativ kann der Treiber 31 als Ausgangstreiber oder als Eingangs/Ausgangstreiber realisiert sein. Weiter umfasst der Halbleiterkörper 30 einen Schaltkreis 32, an den die Spannungsversorgungsschaltung 14 angeschlossen ist. Der Schaltkreis 32 ist über den Treiber 31 mit dem Anschluss 11 gekoppelt. Das Steuersignal ST wird dem Schaltkreis 32 zugeleitet. Der Schaltkreis 32 kann mit Vorteil nach dem Ende eines Hochfrequenzstörungs-Ereignisses beispielsweise eine Messung eines Sensorsignals oder das Abgeben eines Digital- oder AnalogSignals wiederholen. Der Schaltkreis 32 kann als Analogschaltkreis, Digitalschaltkreis oder gemischter Digital-Analog-Schaltkreis implementiert sein. Die Schutzschaltung 10 weist einen weiteren Schaltkreis 33 auf, der über den Treiber 31 mit dem Anschluss 11 gekoppelt ist. Der Anschluss 11 ist als Input/Output Anschluss ausgebildet. Der weitere Schaltkreis 33 kann als Analogschaltkreis, Digitalschaltkreis oder gemischter Digital-Analog-Schaltkreis realisiert sein.

### Bezugszeichenliste

- 10: Schutzschaltung
- 11: Anschluss
- 12: Bezugspotentialanschluss
- 13: Schutzstruktur
- 14: Spannungsversorgungsschaltung
- 15: Bipolartransistor
- 16: Steuereingang
- 17: erster Eingang
- 18: zweiter Eingang
- 19: Spannungsquelle
- 20: Auslöseschaltung
- 20': Schutzstrukturbauelement
- 21: Koppelkondensator
- 22: erste Diode
- 23: zweite Diode
- 24: Knoten
- 25: Pufferkondensator
- 26: weitere Diode
- 27: Schaltmatrix
- 28: erster Transistor
- 29: zweiter Transistor
- 30: Halbleiterkörper
- 31: Treiber
- 32: Schaltkreis
- 33: weiterer Schaltkreis
- AS: Anschlusssignal
- ST: Steuersignal
- VDD: Versorgungsspannung
- VK: Knotenspannung

## Patentansprüche

1. Schutzschaltung, umfassend:
- einen Anschluss (11),
- einen Bezugspotentialanschluss (12),
- eine Schutzstruktur (13), die zwischen dem Anschluss (11) und dem Bezugspotentialanschluss (12) angeordnet und ausgelegt ist, im Fall einer elektrostatischen Entladung zu leiten, und
- eine Spannungsversorgungsschaltung (14), die als Ladungspumpe, welche eingangsseitig an den Anschluss (11) und ausgangsseitig an einen Steuereingang (16) der Schutzstruktur (13) angeschlossen ist, implementiert und ausgelegt ist, im Fall einer Hochfrequenzstörung dem Steuereingang (16) ein Steuersignal (ST) mit einem derartig hohen Spannungswert zuzuführen, dass das Leiten der Schutzstruktur (13) verhindert ist,
wobei die Ladungspumpe von einer Versorgungsspannung (VDD) und von einem Anschlusssignal (AS), das an dem Anschluss (11) anliegt, versorgt wird und wahlweise das Anschlusssignal (AS) oder die Versorgungsspannung (VDD) in das Steuersignal (ST) konvertiert, je nachdem welches der beiden Signale beziehungsweise Spannungen einen höheren Spannungswert hat.

2. Schutzschaltung nach Anspruch 1,
bei der ein Ausgang der Spannungsversorgungsschaltung (14), der an den Steuereingang (16) angeschlossen ist, bei Abwesenheit einer Hochfrequenzstörung hochohmig ist.

3. Schutzschaltung nach Anspruch 1 oder 2,
die Schutzstruktur (13) enthaltend einen Bipolartransistor (15), der als PNP-Bipolartransistor realisiert ist und umfasst:
- einen Emitter, der mit dem Anschluss (11) gekoppelt ist,
- eine Basis, die mit dem Steuereingang (16) gekoppelt ist, und
- einen Kollektor, der mit dem Bezugspotentialanschluss gekoppelt (12) ist.

4. Schutzschaltung nach Anspruch 3,
die Schutzstruktur (13) umfassend eine Auslöseschaltung (20), die eingangsseitig an den Steuereingang (16) und den Anschluss (11) sowie ausgangsseitig an die Basis des Bipolartransistors (15) angeschlossen ist.

5. Schutzschaltung nach einem der Ansprüche 1 bis 4,
bei der die Ladungspumpe ausgelegt ist, das Steuersignal (ST) mit einem Spannungswert bereitzustellen, der höher als ein Spannungswert des Anschlusssignals (AS) ist.

6. Schutzschaltung nach einem der Ansprüche 1 bis 5,
bei der die Spannungsversorgungsschaltung (14) eine Schaltmatrix (27) umfasst mit:
- einem ersten Eingang, der mit dem Anschluss (11) gekoppelt ist,
- einem zweiten Eingang, dem die Versorgungsspannung (VDD) zugeleitet wird, und
- einem Ausgang, der mit dem Steuereingang (16) gekoppelt ist,
wobei das Steuersignal (ST) aus der höheren der am ersten und am zweiten Eingang anliegenden Spannungen (VK, VDD) gebildet wird.

7. Schutzschaltung nach einem der Ansprüche 1 bis 6,
die Spannungsversorgungsschaltung (14) umfassend eine Serienschaltung, die einen Koppelkondensator (21) und eine erste Diode (22) enthält und zwischen dem Anschluss (11) und dem Steuereingang (16) angeordnet ist.

8. Schutzschaltung nach Anspruch 7,
die Spannungsversorgungsschaltung (14) umfassend eine zweite Diode (23), die zwischen dem Bezugspotentialanschluss (12) und einem Knoten (24) zwischen dem Koppelkondensator (21) und der ersten Diode (22) angeordnet ist.

9. Schutzschaltung nach einem der Ansprüche 1 bis 8,
die Spannungsversorgungsschaltung (14) umfassend einen Pufferkondensator (25), der den Steuereingang (16) mit dem Bezugspotentialanschluss (12) verbindet.

10. Verfahren zum Schutz einer Schaltung, umfassend
- Bereitstellen eines Steuersignals (ST) durch eine Spannungsversorgungsschaltung (14) und
- Zuführen des Steuersignals (ST) an eine Schutzstruktur (13), die zwischen einem Anschluss (11) und einem Bezugspotentialanschluss (12) angeordnet und ausgelegt ist, im Fall einer elektrostatischen Entladung zu leiten, wobei im Fall einer Hochfrequenzstörung das Steuersignal (ST) mit einem derartig hohen Spannungswert generiert wird, dass das Leiten der Schutzstruktur (13) verhindert wird, und
wobei die Spannungsversorgungsschaltung (14) als Ladungspumpe implementiert ist, die an einem ersten Eingang an den Anschluss (11) und an einem Ausgang an den Steuereingang (16) angeschlossen ist, die von einer Versorgungsspannung (VDD) und von einem Anschlusssignal (AS), das an dem Anschluss (11) anliegt, versorgt wird und wahlweise das Anschlusssignal (AS) oder die Versorgungsspannung (VDD) in das Steuersignal (ST) konvertiert, je nachdem welches der beiden Signale beziehungsweise Spannungen einen höheren Spannungswert hat.

## Claims

1. A protective circuit, comprising:
- a terminal (11),
- a reference potential terminal (12),
- a protective structure (13) which is arranged between the terminal (11) and the reference potential terminal (12) and configured to be electrically conductive in the event of an electrostatic discharge, and
- a voltage supply circuitry (14) implemented as a charge pump which has its input side connected to the terminal (11) and has its output side connected to a control input (16) of the protective structure (13), said voltage supply circuitry being configured such that in the event of an RF interference it supplies the control input (16) with a control signal (ST) of such a high voltage value that the protective structure (13) is prevented from being electrically conductive,
the charge pump being supplied with a supply voltage (VDD) and a terminal signal (AS) that is applied on the terminal (11) and selectively converting the terminal signal (AS) or the supply voltage (VDD) into the control signal (ST) depending on which one of the two signals or voltages has a higher voltage value.

2. The protective circuit according to claim 1,
in which the voltage supply circuitry's (14) output which is connected to the control input (16) is high-impedance in the absence of an RF interference.

3. The protective circuit according to claim 1 or 2,
the protective structure (13) comprising a bipolar transistor (15) which is realized as a PNP bipolar transistor and comprises:
- an emitter coupled to the terminal (11),
- a base coupled to the control input (16), and
- a collector coupled to the reference potential terminal (12) .

4. The protective circuit according to claim 3,
the protective structure (13) comprising a trigger circuit (20) whose input side is connected to the control input (16) and the terminal (11) and whose output side is connected to the base of the bipolar transistor (15).

5. The protective circuit according to any of claims 1 to 4, in which the charge pump is configured to provide the control signal (ST) with a voltage value which is higher than a voltage value of the terminal signal (AS).

6. The protective circuit according to any of claims 1 to 5, in which the voltage supply circuitry (14) comprises a switching matrix (27) including:
- a first input coupled to the terminal (11),
- a second input which is fed with the supply voltage (VDD), and
- an output coupled to the control input (16),
the control signal (ST) being formed from the higher one of the voltages (VK, VDD) applied on the first and second inputs.

7. The protective circuit according to any of claims 1 to 6, the voltage supply circuitry (14) comprising a series connection which includes a coupling capacitor (21) and a first diode (22) and is arranged between the terminal (11) and the control input (16).

8. The protective circuit according to claim 7,
the voltage supply circuitry (14) comprising a second diode (23) which is arranged between the reference potential terminal (12) and a node (24) between the coupling capacitor (21) and the first diode (22).

9. The protective circuit according to any of claims 1 to 8, the voltage supply circuitry (14) comprising a buffering capacitor (25) connecting the control input (16) to the reference potential terminal (12).

10. A method of protecting a circuit, comprising
- providing a control signal (ST) by means of a voltage supply circuitry (14) and
- supplying the control signal (ST) to a protective structure (13) which is arranged between a terminal (11) and a reference potential terminal (12) and configured to be electrically conductive in the event of an electrostatic discharge, the control signal (ST) being generated in the event of an RF interference so as to have such a high voltage value that the protective structure (13) is prevented from being electrically conductive, and
the voltage supply circuitry (14) being implemented as a charge pump which has a first input connected to the terminal (11) and has an output connected to a control input (16), said charge pump being supplied with a supply voltage (VDD) and a terminal signal (AS) that is applied on the terminal (11), and selectively converting the terminal signal (AS) or the supply voltage (VDD) into the control signal (ST) depending on which one of the two signals or voltages has a higher voltage value.

## Revendications

1. Circuit de protection, comprenant:
- une connexion (11),
- une connexion de potentiel de référence (12),
- une structure de protection (13) qui est disposée entre la connexion (11) et la connexion de potentiel de référence (12) et conçue pour conduire dans le cas d'une décharge électrostatique, et
- un circuit d'alimentation en tension (14) qui est implémenté comme pompe de charge, laquelle est connectée à la connexion (11) côté entrée et à une entrée de commande (16) de la structure de protection (13) côté sortie, et conçu pour acheminer à l'entrée de commande (16), dans le cas d'une perturbation de haute fréquence, un signal de commande (ST) avec une valeur de tension tellement élevée que la conduction de la structure de protection (13) est empêchée,
sachant que la pompe de charge est alimentée par une tension d'alimentation (VDD) et par un signal de connexion (AS) qui est présent au niveau de la connexion (11) et convertit au choix le signal de connexion (AS) ou la tension d'alimentation (VDD) en le signal de commande, selon lequel des deux signaux ou tensions présente une valeur de tension plus élevée.

2. Circuit de protection selon la revendication 1,
dans lequel une sortie du circuit d'alimentation en tension (14) qui est connectée à l'entrée de commande (16) est de valeur ohmique élevée en absence d'une perturbation de haute fréquence.

3. Circuit de protection selon la revendication 1 ou 2,
la structure de protection (13) contenant un transistor bipolaire (15) qui est réalisé comme transistor bipolaire PNP et comprend:
- un émetteur qui est couplé à la connexion (11),
- une base qui est couplée à l'entrée de commande (16), et
- un collecteur qui est couplé à la connexion de potentiel de référence (12).

4. Circuit de protection selon la revendication 3,
la structure de protection (13) comprenant un circuit de déclenchement (20) qui est connecté à l'entrée de commande (16) et à la connexion (11) côté entrée ainsi qu'à la base du transistor bipolaire (15) côté sortie.

5. Circuit de protection selon l'une des revendications 1 à 4,
dans lequel la pompe de charge est conçue pour mettre à disposition le signal de commande (ST) avec une valeur de tension qui est plus élevée qu'une valeur de tension du signal de connexion (AS).

6. Circuit de protection selon l'une des revendications 1 à 5,
dans lequel le circuit d'alimentation en tension (14) comprend une matrice de commutation (27) avec:
- une première entrée qui est couplée à la connexion (11),
- une deuxième entrée à laquelle la tension d'alimentation (VDD) est amenée, et
- une sortie qui est couplée à l'entrée de commande (16), sachant que le signal de commande (ST) est formé à partir de la plus élevée des tensions (VK, VDD) présentes au niveau de la première et de la deuxième entrée.

7. Circuit de protection selon l'une des revendications 1 à 6,
le circuit d'alimentation en tension (14) comprenant un circuit en série qui contient un condensateur de couplage (21) et une première diode (22) et est disposée entre la connexion (11) et l'entrée de commande (16).

8. Circuit de protection selon la revendication 7,
le circuit d'alimentation en tension (14) comprenant une deuxième diode (23) qui est disposée entre la connexion de potentiel de référence (12) et un noeud (24) entre le condensateur de couplage (21) et la première diode (22).

9. Circuit de protection selon l'une des revendications 1 à 8,
le circuit d'alimentation en tension (14) comprenant un condensateur tampon (25) qui relie l'entrée de commande (16) à la connexion de potentiel de référence (12).

10. Procédé de protection d'un circuit, comprenant
- la mise à disposition d'un signal de commande (ST) par un circuit d'alimentation en tension (14) et
- l'acheminement du signal de commande (ST) à une structure de protection (13) qui est disposée entre une connexion (11) et une connexion de potentiel de référence (12) et conçue pour conduire dans le cas d'une décharge électrostatique, et
sachant que, dans le cas d'une perturbation de haute fréquence, le signal de commande (ST) est généré avec une valeur de tension tellement élevée que la conduction de la structure de protection (13) est empêchée, et
sachant que le circuit d'alimentation en tension (14) est implémenté comme pompe de charge qui est connectée à la connexion (11) au niveau d'une première entrée et à l'entrée de commande (16) au niveau d'une sortie, qui est alimentée par une tension d'alimentation (VDD) et par un signal de connexion (AS) qui est présent au niveau de la connexion (11) et qui convertit au choix le signal de connexion (AS) ou la tension d'alimentation (VDD) en le signal de commande (ST), selon lequel des deux signaux ou tensions présente une valeur de tension plus élevée.
